(19) **Europäisches Patentamt / European Patent Office / Office européen des brevets**

(11) **EP 2 073 383 B1**

(12) **EUROPEAN PATENT SPECIFICATION**

(45) Date of publication and mention
of the grant of the patent:
**10.08.2011 Bulletin 2011/32**

(51) Int Cl.:
***H03G 3/30*** *(2006.01)*

(21) Application number: **07254963.7**

(22) Date of filing: **19.12.2007**

(54) **Amplifier arrangement**

Verstärkeranordnung

Agencement d'amplificateur

(84) Designated Contracting States:
**DE FR GB**

(43) Date of publication of application:
**24.06.2009 Bulletin 2009/26**

(73) Proprietor: **Sequans Communications
Reading RG41 5RB (GB)**

(72) Inventor: **Garg, Nitin
Reading RG41 5RB (GB)**

(74) Representative: **Neobard, William John et al
Kilburn & Strode LLP
20 Red Lion Street
London WC1R 4PJ (GB)**

(56) References cited:
**EP-A- 0 424 009     EP-A- 0 473 299
EP-A- 0 701 332     EP-A- 1 083 668
WO-A-01/11769       GB-A- 2 161 335
US-A- 6 091 942**

**Description**

The present invention relates generally to amplifiers, and more specifically but not exclusively to method of controlling the gain of an RF amplifier device and to a gain-controlled RF amplifier system.

The gain control of an open-loop amplifier (small signal or large signal) is usually done by varying one or more of the gain parameters e.g. Gm (transconductance of the transistor), magnitude of source or load impedance etc, thus achieving a range of gain values.

Amplifier circuits realized using physical devices available in an integrated circuit process (e.g. transistors, resistors, capacitors etc) are subject to uncontrollable statistical variations in process, supply voltage and temperature (PVT). Therefore amplifier gain can drift from the desired gain value due to PVT variations. This problem may be alleviated in DC and low-frequency amplifiers by employing the technique of negative feedback; here open-loop gain of the amplifier is traded off to reduce the effects of PVT variations.

The application of similar techniques for gain control is usually not affordable in RF amplifiers because of scarcity of available gain at high frequencies within reasonable power consumption. RF amplifiers therefore tend to be operated in open-loop fashion that makes them susceptible to change in their performance (e.g. Gain) due to PVT variations.

Some prior art documents include US-A- 5768694 and US-A-7065155.

US-A-5768694 discloses an AGC circuit used in radio transmitters for satellite communications and the like intended to eliminate non-linearity compensators for detectors and reduce the radio transmitters in size and complexity. An RF input signal is amplified and output while passing through input splitting means, programmable attenuator, amplifier, and output splitting means. At the same time, a part of the RF input signal branches off at the input splitting means to input detecting means, where it is detected so as to obtain an input signal amplitude. In addition, a part of the amplifier output is split off at the output splitting means, then attenuated by attenuation means and finally reaches output detecting means, where the signal is detected so as to obtain an output signal amplitude after attenuation. Control means adjusts the attenuation factor of the programmable attenuator so that the input of the input detecting means will be equal to the input of the output detecting means.

US-A-7065155 discloses a transceiver and a method of operating the same that includes in the transmitter a power control circuit that operates on an analog differential signal containing data packets individually. The power control circuit initially transmits a series of data symbols with known values, periodically strobes the transceiver system for correct power levels and incrementally increases the power level of the transceiver until the optimal gain is reached, without exceeding the maximum output power.

Further prior art documents include EP-A-473299, GB-A-2161335, US-A-6091942, EP-A-424009, EP-A-1083668, WO-A-01/11769 and EP-A-701332.

In EP-A-472399 RF power is sampled and measured at the input and output of a solid state power amplifier using directional couplers and matched square law detectors (60,61). Outputs from the detectors are applied to differential inputs of a DC operational amplifier (62). Outputs from the detectors are compared and filtered in the operational amplifier and the resulting difference signal is applied to a control input on a switching type power supply (64). The power supply converts a DC input voltage to the various positive and negative voltages required to operate the RF devices (72-75) in the solid state power amplifier. When the control loop is closed, the supply voltage varies to maintain a constant operating point resulting in constant gain, efficiency, and linearity for the overall solid state power amplifier despite variations in signal levels and signal composition.; In another embodiment, the solid state power amplifier has a series of single-ended low power amplifiers terminating in an output high power module. In the output module, one medium power device acts as a driver stage (45) for four high power devices (72-75) connected in parallel. The output stages are hybrid coupled, and isolators before and after these hybrid coupled output stages isolate the driver from the final amplifiers and protect the output devices from reflected signals. A dynamically controlled PIN diode variable attenuator (42) at the amplifier input allows the operating point of the amplifier to be selected and adjusted while the closed loop function is in operation. A hybrid matrix power amplifier system is also disclosed

In GB-A-2161336 a power amplifier has plural amplification circuits of different gains selectively actuable to zero and maximum gains, and electronic switches to select a circuit for connection to a common output junction

In US-A-6091942, a K-band amplifier circuit (10) with two samplers (12, 18) is coupled to detectors (22, 26) that detect an input and an output RF signal level. These two reference signals are provided to a differential gain control circuit (24) which is coupled to one or more variable gain amplifier (VGA) (14) stages. The VGAs compensate for the gain of an entire chain of amplifiers (16). When the individual amplifier gains vary for any reason, (i.e., process, temperature effects or end of life degradation) the variation in gain causes higher or lower levels of detected output reference signals for a given RF input signal. The gain control circuit (24) drives the VGA (14) up or down as appropriate. By maintaining a constant offset in input and output reference control signals, the gain control circuit (24) drives the amplifier chain (16) to a constant gain.

EP-A-424009 discloses an automatic gain control circuit (AGC) in a receiver for a digital radio telephone. Most of the total gain control of the received signal is accomplished in the base band frequency sections, in the I and Q branches whereof the signal amplification is controlled step by step, and only a minor part of the total gain control is performed in the RF stage. High amplification steps are formed by means of amplifiers (9a, 10a, 11a, 12a; 9b, 10b, 11b, 12b), of which the desired amplifier is activated by means of a digitally controlled (A, B) multiplexer (13a, 13b), and low amplification steps are formed by means of a resistance attenuator (14a, 14b), in which a signal of desired level is selected by means of a digitally controlled (C, D, E) multiplexer (15a, 15b).; In addition, the RF amplifier (2) has two amplification levels, of which the desired amplification is selected by means of a digital control (F). By means of different digital control combinations (A, B, C, D, E, F) the entire gain control range required of the receiver can be covered.

In EP-A-1083668, At the onset of an operation, a level of a base band signal at an input side of a variable gain amplifying circuit 8 is detected by a logarithmic amplifier 11 having a wide dynamic range, and, a control unit 18 controls a gain of a low-noise amplifier 15 in a previous step of a low-pass filter 7 based on the detected level and also controls a gain of variable gain amplifier 8, whereby saturation at an analog base band portion is prevented even when the level of the input signal is high.

In WO-A-01/11769 each radio of a plurality of radios includes a plurality of variable gain stages connected in series. The radio further includes at least one power detector connected to the variable gain stages, a temperature sensor, and a processor for controlling the variable gain stages in-service based upon the at least one power detector, the temperature sensor, and stored frequency and power compensation values. A method for calibrating each radio includes generating frequency compensation values for at least one first variable gain stage by supplying a first calibration signal swept in frequency while maintaining the radio at a constant temperature. The method further includes generating power compensation values for at least one second variable gain stage by supplying a second calibration signal swept in power level and while maintaining the radio receiver at a constant temperature

In EP-A-701332, a gain switching circuit comprises first and second gain stages (20A,20B) connected in parallel between the input terminal and the output terminal, and a control unit (24) for allowing the first and second gain stages to be selectively operative, wherein the first and second gain stages respectively include input sections (21a,21b) in which input impedance values viewed from the input terminal are substantially equal to each other, and output sections (23a,23b) in which output impedance values viewed from the output terminal are substantially equal to each other. By this configuration, a gain switching circuit and a radio apparatus using such a gain switching circuit adapted so that input/output impedance does not fluctuate are provided without implementing switching between gain stages

It is an aim of embodiments of the present invention to allow for gain to be controlled accurately or stabilized over a range of values (both negative and positive) and eliminating variation due to PVT effects without sacrificing open-loop gain.

The invention is defined in the appended independent claims and some features of embodiments are recited in the dependent claims.

Embodiments allow gain control without change of biasing conditions of the gain stages. In these embodiments, gain is controlled by the number of individual gain stages switched ON at the time. Consequently, the gain control range is only limited by the number of individual gain stages connected in parallel.

The digital gain control technique is digital in operation and thus can be readily read, written to and stored for further computation by means of hardware or software control e.g. baseband chip in wireless communication transceiver.

Embodiments of the invention enable a technique of RF amplification whereby gain can be precisely controlled and/or made independent of process, supply voltage and temperature variations automatically.

The invention will be more clearly understood by referring to the following description of embodiments, shown by way of example only. In the drawings:

Figure 1 shows a block diagram of an embodiment of a gain-controlled RF amplifier system.

Figure 2 shows a block diagram of an embodiment of a gain-controller down conversion system

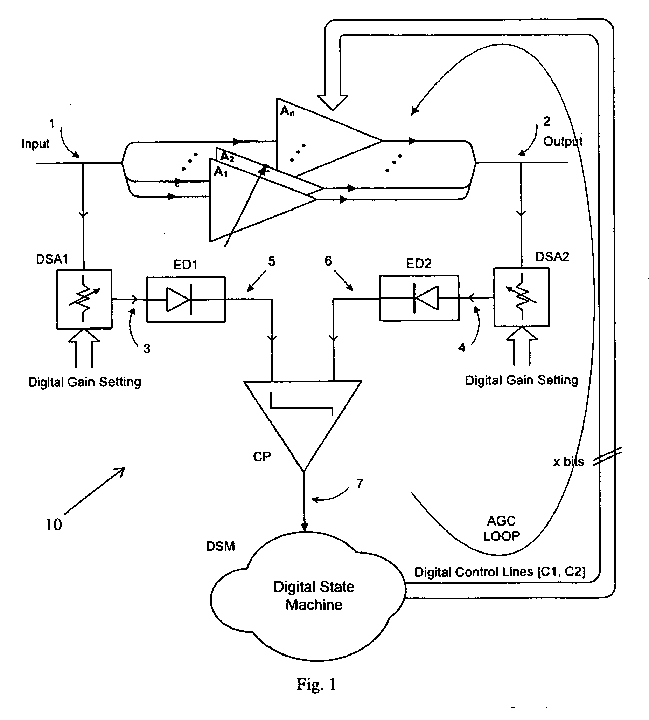

Refer to Figure 1, an amplifier system 10 consists of a plurality of individual RF gain stages $A_1$-An, also referred to herein as "amplifier devices", connected generally in parallel between an input node 1 and an output node 2. A first tapped attenuator DSA1 is connected between the input node 1 and a reference potential (not shown); the tap of the attenuator DSA1 is a first tap node 3. A second tapped attenuator DSA2 is connected between the output node 2 and a reference potential (not shown); the tap of the attenuator DSA2 is a second tap node 4.

In this embodiment, a first envelope detector ED1 is connected between the first tap node 3 and a first input node 5 of a comparator CP. A second envelope detector ED2 is connected between the second tap node 4 and a second input node 6 of the comparator CP. The comparator CP has an output node 7, which is connected to a digital state machine DSM. The digital state machine is connected to the respective gain stages $A_1$-An via plural control lines 11. A first set of control signals C1 is provided by the digital state machine to switch respective gain stages into and out of circuit.

Other embodiments use different detector devices, rather than envelope detectors. For example, peak detectors or RMS measuring devices or averaging circuits may be used, where appropriate to the desired effect.

The position of the tap point on each tapped attenuator, and hence the proportion of the respective input signal supplied to the respective tap point, of this embodiment is controllable by a digital gain control signal CS.

In this embodiment each gain stage is not only switchable by the first control signal CI, but also has a variable gain that is controlled by another digital control signal C2. G(i) is the gain of $i_{th}$ gain stage of the amplifier system and is defined as following function:

$$G(i) = f\left(g_{fixed}(i), C1(i), C2(i)\right)$$

where

$g_{fixed}(i)$ is the fixed gain of the $i_{th}$ stage

C1($i$) is a digital control signal acting on the $i_{th}$ stage to switch the stage in or out of circuit

C2($i$) is a digital control signal to vary the gain of the $i_{th}$ stage

The overall gain of the amplifier system is digitally programmable over user-defined range by means of control signals C1 and C2.

The actual gain $G_a$ of the amplifier system is defined as the ratio of the RF signal at node 2 to that at node 1. Further it is equal to the summation of gain values of all N individual stages, each of which is dependent on the state of respective digital control signals [C1, C2].

$$G_a = \frac{S_2}{S_1} = \sum_{i=1}^{i=N} f\left(g_{fixed}(i), C1(i), C2(i)\right)$$

The desired gain setting of the amplifier system is denoted as $G_d$ which is a set of user-defined values spanning a range from $G_{d,low}$ to $G_{d,high}$ with discrete unit step $\Delta_{Gd}$.

$$G_d = \left\{G_{d,low}...G_{di}...G_{d,high}\right\}$$

where $G_{di}$, the $i_{th}$ member of set $G_d$, is defined as

$$G_{di} = G_{d,low} + i.\Delta_{G_d}$$

The resolution of the amplifier gain discrete step is designed to be greater than the resolution of discrete unit step of the desired gain values.

Therefore,

$$\min\left(G(i)\right) \leq \Delta_{G_d}$$

An automatic gain control scheme regulates the actual gain $G_a$ of the amplifier system, to keep it equal to the desired gain setting of the amplifier, $G_d$, in response to any intended change in $G_d$ such as setting a different gain value or unintended deviation, for instance due to process, supply voltage or temperature variations. The AGC scheme functions as follows:

Digital Step Attenuators DSA1 and DSA2 have high input impedance; therefore, their loading on the signal path circuitry of the amplifier is insignificant and does not affect the actual information in the signal. The function of DSA1 and DSA2 is to attenuate the sensed signal linearly in relation to the desired gain setting, $G_d$, of the amplifier system. The DSA attenuation value is based on the ratio of the values of passive devices available in an IC process (e.g. resistors or capacitors). The resistors or capacitors in a modem IC process can be manufactured to precise values and their PVT variations can be matched to a high degree of accuracy. Therefore, an attenuation value based on ratio of values of resistors or capacitors is highly accurate even in presence of PVT variations.

DSA1's set of discrete attenuation values $AT_1$ is equal to the subset of $G_d$ whose values are <1 in magnitude or equivalently <0 in dB terms. DSA2's set of discrete attenuation values $AT_2$ is equal to the subset of $G_d$ whose values are >1 in magnitude or equivalently >0 in dB terms.

$$AT_1 \subseteq G_d : |G_{di}| < 1, or, dB(G_{di}) < 0$$

$$\subseteq 1 : |G_{di}| \geq 1, or, dB(G_{di}) > 0$$

$$AT_2 \subseteq (G_d)^{-1} : |G_{di}| > 1, or, dB(G_{di}) > 0$$

$$\subseteq 1 : |G_{di}| \leq 1, or, dB(G_{di}) < 0$$

Further it is postulated that

$$\frac{AT_1}{AT_2} = G_d$$

In one embodiment, DSAs are implemented as digitally programmable resistor ladder attenuators with discrete set of attenuation values as defined above. Other alternatives for example capacitors are possible.

If the desired gain $|G_d|$ is set as < 1 or equivalently $dB(G_d) < 0$, then DSA1 attenuates the signal at node 1 by value of $AT_1$ and DSA2 provides no attenuation to the signal at node 2. Similarly, if the desired gain $|G_d|$ is set as > 1 or equivalently $dB(G_d) > 0$, then DSA2 attenuates the signal at node 2 by value of $AT_2$ and DSA1 provides no attenuation to the signal at node 1. The outputs of DSA1 and DSA2 are available at nodes 3 and 4 respectively. The signals S3 and S4 at nodes 3 and 4 respectively can be written as:

$$S_3 = AT_1.S_1$$

$$S_4 = AT_2.S_2$$

Nodes 3 and 4 are coupled to the input of envelope detectors ED1 and ED2 respectively. ED1 and ED2 convert the RF signals S3 and S4 to equivalent quasi-dc signals S5 and S6 available at the output of envelope detectors at nodes 5 and 6 respectively.

Nodes 5 and 6 are coupled to the input of a comparator labeled CP. The comparator senses the difference in signals S5 and S6 and outputs a binary digital signal S7 at node 7 based on the polarity of the difference between signals S5 and S6. The digital signal S7 is coupled to a Digital State Machine labeled DSM which is implemented as a logic computation circuit. DSM computes a digital control signal [C1, C2] that is fed back to the amplifier to control its gain. The digital control signal [C1, C2] acts in opposite to the sense of difference in S3 and S4, thus giving a negative feedback signal to the amplifier. To illustrate the working of this negative feedback loop, consider $G_a$ to be greater than $G_d$. Therefore, S4(S6) would be greater than S3(S5). The comparator outputs a binary digital signal S7 to indicate this condition to DSM which in turn produces digital control signal [C1, C2] to *reduce* the gain of the amplifier. The negative feedback will continue to act till the following condition is enforced,

$$S_3 = S_4$$

or,

$$AT_1 \times S_1 = AT_2 \times S_2$$

or,

$$\frac{AT_1}{AT_2} = \frac{S_2}{S_1}$$

which leads to

$$G_d = G_a$$

Thus, the AGC Loop automatically controls the RF amplifier gain to equal to the digitally programmable desired gain setting and in the process eliminating effects of any PVT variations.

Embodiments may have the following advantages:

1) Enables RF amplification circuits to become more robust to inherent PVT variations in real world conditions.

2) Savings in silicon area and power consumption as these circuits need not be over-designed by large margins to counter PVT variations.

3) No need to calibrate the deviations in these circuits due to PVT effects.

In other embodiments, the gain stages are constant in gain, and are merely switched into and out of circuit to provide gain control. In some embodiments, at least one gain stage is not switchable and is always in circuit. In yet other embodiments, at least one gain stage is in series with another gain stage. In that case a "disabled" gain stage may have unity gain when in the disabled state.

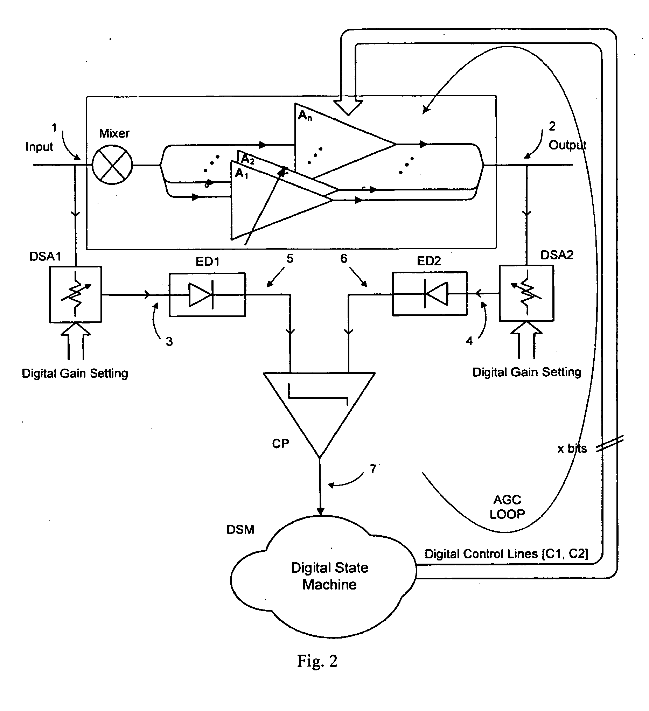

Refer to Fig 2, in another embodiment, there is a frequency down conversion block, herein referred to as 'Mixer' connected between node1 and input of the amplifier or similarly between output of the amplifier and node 2. Thus the frequency f1 of input signal S 1 may be different from the frequency f2 of output signal S2.

The mixer may alternatively be used for up-conversion in a further embodiment.

If an up converter then f2 > f1 or if a down converter then f1 > f2. The mixer may have a gain or loss value of its own.

This embodiment illustrates the gain control mechanism of the combined amplifier and mixer such that the combined gain is regulated to a user-specified gain setting and gain variations due to PVT effects are eliminated.

The invention is not restricted to features of the described embodiments.

**Claims**

1. A method of controlling the gain of an RF amplifier device having an input signal and an output signal, the amplifier device comprising plural amplifiers, the method comprising
selectively enabling and disabling said amplifiers; **characterised in that**: said amplifiers are connected in parallel; and the method comprises:
comparing a measure of magnitude of the input signal to a like measure of magnitude of the output signal; and using a result of the comparison to selectively enable a desired plurality of said parallel-connected amplifiers.

2. A method according to claim 1, further comprising using a result of the comparison to control a gain of at least one enabled amplifier.

3. A method according to claim 1 or 2, further comprising scaling at least one of the input signal and the output signal.

4. A method according to any preceding claim, wherein said using step comprises applying a comparison result to a digital state machine to derive digital control signals for enabling respective amplifiers.

5. A gain-controlled RF amplifier system having an input node and an output node, comprising
a plurality of amplifier devices, each amplifier being capable of being selectively enabled and disabled
**characterised by**
the amplifiers being connected in parallel between the input and output nodes;
means for comparing a magnitude of a signal input to the input node against a magnitude of a signal output from the output node;
control means responsive to the comparison result to selectively enable a desired plurality of amplifier devices.

6. A gain-controlled RF amplifier system according to claim 5, wherein the control means is responsive to the comparison result to vary the gain of at least one amplifier device

7. A gain-controlled RF amplifier system according to claim 5 or 6, wherein the amplifier devices are generally in parallel.

8. A gain-controlled RF amplifier system according to claim 5 or 6, wherein at least one amplifier is in series with another amplifier device.

9. A gain-controlled RF amplifier system according to any one of claims 5-8, having a digital state machine configured to receive the comparison result, thereby to provide digital control signals to control respective amplifier devices

10. A gain-controlled RF amplifier system according to any of claims 5-9, having at least one controllable scaling device for providing the or each input to a magnitude comparator.

11. A gain-controlled RF amplifier system according to any one of claims 5-9
having a impedance network connected between at least one of the input and output node and a reference, the network having a tap, a detector device connected to the tap, and an output of the detector device being connected to a comparator.

12. A gain-controlled RF amplifier system according to claim 11, wherein the impedance network is passive.

13. A gain-controlled RF amplifier system according to claim 11 or 12, wherein the detector device is one of the group comprising an envelope detector, a peak value circuit, an RMS detecting circuit and an average value circuit.

14. A gain-controlled RF amplifier system according to any preceding claim, having a frequency conversion device, whereby the comparing means is configured to compare a magnitude of a signal at a first frequency, input to the input node, against a magnitude of a signal at a second frequency, output from the output node.

**Patentansprüche**

1. Verfahren zum Regeln der Verstärkung einer HF-Verstärkervorrichtung mit einem Eingangssignal und einem Ausgangssignal, wobei die Verstärkervorrichtung mehrere Verstärker aufweist, wobei das Verfahren umfasst:

   selektives Freigeben und Sperren der Verstärker;
   **dadurch gekennzeichnet, dass**
   die Verstärker parallel geschaltet sind;
   und dass das Verfahren umfasst:

      Vergleichen einer Größe des Eingangssignals mit einer gleichen Größe des Ausgangssignals; und
      Verwenden eines Ergebnisses des Vergleichs, um eine gewünschte Mehrzahl der parallel geschalteten Verstärker selektiv zu aktivieren.

2. Verfahren nach Anspruch 1, das des Weiteren das Verwenden eines Ergebnisses des Vergleichs umfasst, um die Verstärkung wenigstens eines freigegebenen Verstärkers zu regeln.

3. Verfahren nach Anspruch 1 oder 2, das des Weiteren das Skalieren wenigstens eines von Eingangssignal und Ausgangssignal umfasst.

4. Verfahren nach einem der vorhergehenden Ansprüche, wobei der Schritt des Verwendens das Anwenden eines Vergleichsergebnisses auf eine digitale Zustandsmaschine umfasst, um digitale Steuersignale zum Freigeben entsprechender Verstärker abzuleiten.

5. Verstärkungsgeregeltes HF-Verstärkersystem mit einem Eingangsknoten und einem Ausgangsknoten, das aufweist:

      eine Vielzahl von Verstärkervorrichtungen, wobei jeder Verstärker selektiv freigegeben und gesperrt werden kann;
      **gekennzeichnet durch** Parallelschalten der Verstärker zwischen die Eingangs- und Ausgangsknoten;
      Einrichtungen zum Vergleichen einer Größe eines Eingangssignals in den Eingangsknoten mit einer Größe eines Ausgangssignals aus dem Ausgangsknoten;
      Regeleinrichtungen, die auf das Vergleichsergebnis ansprechen, um eine gewünschte Mehrzahl von Verstärkereinrichtungen selektiv freizugeben.

6. Verstärkungsgeregeltes HF-Verstärkersystem nach Anspruch 5, wobei die Regeleinrichtung auf das Vergleichsergebnis anspricht, um die Verstärkung wenigstens einer Verstärkervorrichtung zu variieren.

7. Verstärkungsgeregeltes HF-Verstärkersystem nach Anspruch 5 oder 6, wobei die Verstärkervorrichtungen allgemein parallel sind.

8. Verstärkungsgeregeltes HF-Verstärkersystem nach Anspruch 5 oder 6, wobei wenigstens ein Verstärker mit einer anderen Verstärkervorrichtung in Reihe geschaltet ist.

9. Verstärkungsgeregeltes HF-Verstärkersystem nach einem der Ansprüche 5 bis 8, mit einer digitalen Zustandsmaschine, die konfiguriert ist, um das Vergleichsergebnis zu empfangen, um **dadurch** digitale Regelsignale zum Regeln entsprechender Verstärkervorrichtungen zu liefern.

10. Verstärkungsgeregeltes HF-Verstärkersystem nach einem der Ansprüche 5 bis 9, mit wenigstens einer regelbaren Skaliervorrichtung zum Liefern des oder jedes Eingangs an einen Größenkomparator.

11. Verstärkungsgeregeltes HF-Verstärkersystem nach einem der Ansprüche 5 bis 9, mit einem Impedanznetzwerk, das zwischen wenigstens einen der Eingangs- und Ausgangsknoten und eine Referenz geschaltet ist, wobei das Netzwerk einen Abgriff hat, eine Detektorvorrichtung, die mit dem Abgriff verbunden ist, und wobei ein Ausgang der Detektorvorrichtung mit einem Komparator verbunden wird.

**12.** Verstärkungsgeregeltes HF-Verstärkersystem nach Anspruch 11, wobei das Impedanznetzwerk passiv ist.

**13.** Verstärkungsgeregeltes HF-Verstärkersystem nach Anspruch 11 oder 12, wobei die Detektorvorrichtung eine der Gruppe ist, die einen Hüllkurvendetektor, eine Spitzenwertschaltung, eine RMS-Detektorschaltung und eine Mittelwertschaltung aufweist.

**14.** Verstärkungsgeregeltes HF-Verstärkersystem nach einem der vorhergehenden Ansprüche mit einer Frequenzwandlervorrichtung, wobei die Vergleichseinrichtung konfiguriert ist, um die Größe eines Signals mit einer ersten Frequenz, eingegeben in den Eingangsknoten, mit der Größe eines Signals mit einer zweiten Frequenz, ausgegeben aus dem Ausgangsknoten, zu vergleichen.

**Revendications**

**1.** Procédé de commande du gain d'un dispositif d'amplificateur RF ayant un signal d'entrée et un signal de sortie, le dispositif d'amplificateur comprenant plusieurs amplificateurs, le procédé comprenant les étapes consistant à :

activer et désactiver sélectivement lesdits amplificateurs ; **caractérisé en ce que** :

lesdits amplificateurs sont connectés en parallèle, et le procédé comprend les étapes consistant à :

comparer une mesure de grandeur du signal d'entrée à une mesure de grandeur similaire du signal de sortie ; et utiliser un résultat de la comparaison pour activer sélectivement une pluralité souhaitée desdits amplificateurs connectés en parallèle.

**2.** Procédé selon la revendication 1, comprenant en outre l'étape consistant à utiliser un résultat de la comparaison pour commander un gain d'au moins un amplificateur activé.

**3.** Procédé selon la revendication 1 ou 2, comprenant en outre l'étape consistant à mettre à l'échelle au moins un élément parmi le signal d'entrée et le signal de sortie.

**4.** Procédé selon l'une quelconque des revendications précédentes, dans lequel ladite étape d'utilisation comprend l'application d'un résultat de comparaison à une machine d'état numérique pour dériver des signaux de commande numériques permettant d'activer des amplificateurs respectifs.

**5.** Système d'amplificateur RF à gain commandé comportant un noeud d'entrée et un noeud de sortie, comprenant :

une pluralité de dispositifs d'amplificateur, chaque amplificateur étant capable d'être sélectivement activé et désactivé ;
**caractérisé par** :

la connexion en parallèle des amplificateurs entre les noeuds d'entrée et de sortie ;
un moyen pour comparer une grandeur d'un signal fourni en entrée au noeud d'entrée à une grandeur d'un signal fourni en sortie à partir du noeud de sortie ;
un moyen de commande réactif au résultat de comparaison pour activer sélectivement une pluralité souhaitée de dispositifs d'amplificateur.

**6.** Système d'amplificateur RF à gain commandé selon la revendication 5, dans lequel le moyen de commande est réactif au résultat de comparaison pour faire varier le gain d'au moins un dispositif d'amplificateur.

**7.** Système d'amplificateur RF à gain commandé selon la revendication 5 ou 6, dans lequel les dispositifs d'amplificateur sont généralement en parallèle.

**8.** Système d'amplificateur RF à gain commandé selon la revendication 5 ou 6, dans lequel au moins un amplificateur est en série avec un autre dispositif d'amplificateur.

9. Système d'amplificateur RF à gain commandé selon l'une quelconque des revendications 5 à 8, ayant une machine d'état numérique configurée pour recevoir le résultat de comparaison, pour fournir ainsi des signaux de commande numériques pour commander les dispositifs d'amplificateur respectifs.

10. Système d'amplificateur RF à gain commandé selon l'une quelconque des revendications 5 à 9, ayant au moins un dispositif de mise à l'échelle commandable permettant de fournir l'entrée ou chaque entrée à un comparateur de grandeur.

11. Système d'amplificateur RF à gain commandé selon l'une quelconque des revendications 5 à 9, ayant un réseau d'impédance connecté entre au moins un élément parmi le noeud d'entrée et le noeud de sortie et une référence, le réseau comportant un branchement, un dispositif de détecteur connecté au branchement, et une sortie du dispositif de détecteur étant connectée à un comparateur.

12. Système d'amplificateur RF à gain commandé selon la revendication 11, dans lequel le réseau d'impédance est passif.

13. Système d'amplificateur RF à gain commandé selon la revendication 11 ou 12, dans lequel le dispositif de détecteur est l'un du groupe comprenant un détecteur d'enveloppe, un circuit de valeur pic, un circuit de détection RMS et un circuit de valeur moyenne.

14. Système d'amplificateur RF à gain commandé selon l'une quelconque des revendications précédentes, ayant un dispositif de conversion de fréquence, moyennant quoi le moyen de comparaison est configuré pour comparer une grandeur d'un signal à une première fréquence, fourni en entrée au noeud d'entrée, à une grandeur d'un signal à une seconde fréquence, fourni en sortie à partir du noeud de sortie.

Fig. 1

Fig. 2

**REFERENCES CITED IN THE DESCRIPTION**

**Patent documents cited in the description**

- US 5768694 A
- US 7065155 A
- EP 473299 A
- GB 2161335 A
- US 6091942 A
- EP 424009 A
- EP 1083668 A
- WO 0111769 A
- EP 701332 A
- EP 472399 A
- GB 2161336 A